Europäisches Patentamt

European Patent Office

Office européen des brevets

(19)

(11) **EP 1 548 948 A1**

(12) **EUROPEAN PATENT APPLICATION**

(43) Date of publication:
**29.06.2005 Bulletin 2005/26**

(51) Int Cl.7: **H03M 13/11**, H04L 12/56

(21) Application number: **04030172.3**

(22) Date of filing: **20.12.2004**

| | |
|---|---|
| (84) Designated Contracting States:<br>**AT BE BG CH CY CZ DE DK EE ES FI FR GB GR HU IE IS IT LI LT LU MC NL PL PT RO SE SI SK TR**<br>Designated Extension States:<br>**AL BA HR LV MK YU**<br><br>(30) Priority: **19.12.2003 KR 2003093944**<br><br>(71) Applicant: **Samsung Electronics Co., Ltd.**<br>**Suwon-si, Gyeonggi-do (KR)**<br><br>(72) Inventors:<br>• **Jeong, Hong-Sil**<br>**Yeongtong-gu Suwon-si Gyeonggi-do (KR)** | • **Kyung, Gyu-Bum**<br>**Yeongtong-gu Suwon-si Gyeonggi-do (KR)**<br>• **Kim, Jae-Yoel**<br>**Yeongtong-gu Suwon-si Gyeonggi-do (KR)**<br>• **Park, Sung-Eun**<br>**Yeongtong-gu Suwon-si Gyeonggi-do (KR)**<br><br>(74) Representative: **Grünecker, Kinkeldey,**<br>**Stockmair & Schwanhäusser Anwaltssozietät**<br>**Maximilianstrasse 58**<br>**80538 München (DE)** |

(54) **Apparatus and method for transmitting and receiving coded data by encoder having unequal error probability in mobile communication system**

(57) Disclosed is an apparatus for transmitting information bits after coding the information bits with Low Density Parity Check (LDPC) codes having unequal error probability values in a wireless communication system which channel-codes and transmits the information bits. The apparatus includes a LDPC encoder for mapping high information bits to low variable nodes and low information bits to high variable nodes, the high information bits having high importance priorities and the low information bits having low importance priorities from among the information bits, wherein the low variable nodes are variable nodes having low error probability values and the high variable nodes are variable nodes having high error probability values in a factor graph of the LDPC codes.

$$H = \begin{bmatrix} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 1 & 0 & 1 & 1 & 0 & 0 & 1 \end{bmatrix}$$

# FIG.1

**Description**

**BACKGROUND OF THE INVENTION**

1. Field of the Invention

The present invention relates to a mobile communication system, and more particularly to an apparatus and a method for transmitting and receiving coded data by a encoder having unequal error probability values.

2. Description of the Related Art

With the introduction of a cellular mobile communication system in the U.S. in the late 1970's, South Korea started to provide a voice communication service in an Advanced Mobile Phone Service (AMPS) system, a first generation (1G) analog mobile communication system. In the mid 1990's, South Korea commercialized a Code Division Multiple Access (CDMA) system, a second generation (2G) mobile communication system, to provide voice and low-speed data services.

In the late 1990's, South Korea partially deployed an IMT-2000 (International Mobile Telecommunication-2000) system, a third generation (3G) mobile communication system, aimed at providing advanced wireless multimedia services, worldwide roaming, and high-speed data services. The 3G mobile communication system was especially developed to transmit data at a high rate in compliance with the rapid increase in the amount of serviced data. That is, the 3G mobile communication system has evolved into a packet service communication system, and the packet service communication system transmits burst packet data to a plurality of mobile stations and is designed for the transmission of mass data. The packet service communication system is being developed for a high-speed packet service.

The 3G mobile communication system is evolving into a fourth generation (4G) mobile communication system. The 4G mobile communication system is currently being developed for standardizing the interworking and integration between a wired communication network and a wireless communication network beyond simple wireless communication service which the previous-generation mobile communication systems provided. Technology for transmitting large volumes of data at and up to a capacity level available in the wired communication network must be developed for the wireless communication network.

Meanwhile, importance of control information is increasing as the necessity for a high-quality, high-reliability communication system increases. One of the methods proposed for such a high-quality, high-reliability communication system is an Adaptive Modulation and Coding (AMC) scheme.

The AMC scheme applies different coding rates and different modulation schemes according to channel conditions. Specifically, the AMC scheme applies high-degree coding rate and modulation scheme to a channel of a high channel quality so that data can be transmitted through the high quality channel at a high speed and low-degree coding rate and modulation scheme to a channel of a low channel quality, thereby improving the reliability of the transmitted signal.

However, when the control information indicating the channel condition is erroneous, the control information may be erroneously decoded in spite of the low channel condition and the coding rate and modulation scheme for the high quality channel may be erroneously used in transmitting data through the low quality channel. Then, it is impossible to construct a high-quality communication system.

Hereinafter, control information used in the AMC scheme will be described in detail as an example of information requiring unequal error information. The control information used in the AMC scheme classifies the channel condition into sixteen levels from 0 to a maximum. In general, the control information has four or five bits. For the sake of convenience, on an assumption that the control information has one of values from 0 to 15 expressed by four (binary) bits, the control information can be expressed by Table 1 as shown below.

Table 1

| AMC level | Control information bit |
| --- | --- |
| 0 | 0000 |
| 1 | 0001 |
| 2 | 0010 |
| 3 | 0011 |
| 4 | 0100 |
| 5 | 0101 |
| 6 | 0110 |
| 7 | 0111 |
| 8 | 1000 |
| 9 | 1001 |
| 10 | 1010 |
| 11 | 1011 |
| 12 | 1100 |
| 13 | 1101 |
| 14 | 1110 |
| 15 | 1111 |

Referring to Table. 1, when the fifteenth grade control information '1111' is transmitted, if the last bit is erroneous and the information is erroneously received as '1110', the AMC level is misinterpreted as the fourteenth grade instead of the fifteenth grade. In contrast, if the first bit of the fifteenth grade control information '1111' is erroneous and the information is erroneously received as '0111' instead of '1111', the AMC level is misinterpreted as the seventh grade. Therefore, control information having an erroneous first bit has larger loss for channel information than control information having an erroneous last bit. Therefore, it is preferred that the control information has less error in the first bit than in the last bit.

As described above, in order to construct a communication system having a high quality and high reliability, codes for applying unequal error probability values or different importance priorities to bits as well as enabling the bits to have less error in the first bit than in the last bit arc necessary in transmitting data such as control information, bits of which have different reliabilities.

However, it is difficult to make a design for providing the unequal error probability values to typical linear block codes using conventional non-iterative decoding which gives weight to minimum distance. That is to say, each bit of the typical block code has nearly the same error probability value and it is very difficult to design a encoder capable of coding the transmitted bits with different error probability values.

## SUMMARY OF THE INVENTION

Accordingly, the present invention has been made to solve the above-mentioned problems occurring in the prior art, and an object of the present invention is to provide an apparatus and a method for transmitting bits while applying different error probability values to the transmitted bits by using unequal Low Density Parity Check (LDPC) codes.

It is another object of the present invention to provide an apparatus and a method for transmitting higher-quality data by coding control information requiring unequal error probability values by means of unequal LDPC codes.

In order to accomplish these objects, there is provided an apparatus for transmitting information bits after coding the information bits with Low Density Parity Check (LDPC) codes having unequal error probability values in a wireless communication system which channel-codes and transmits the information bits. The apparatus comprises a LDPC encoder for mapping high information bits to low variable nodes and low information bits to high variable nodes, the high information bits having high importance priorities and the low information bits having low importance priorities from among the information bits, wherein the low variable nodes are variable nodes having low error probability values and the high variable nodes are variable nodes having high error probability values in a factor graph of the LDPC codes.

In accordance with another aspect of the present invention, there is provided an apparatus for receiving information bits coded with Low Density Priority Check (LDPC) codes having unequal error probability values in a wireless communication system which channel-codes and transmits the information bits. The apparatus comprises a LDPC decoder for de-mapping corresponding to a predetermined encoder for mapping high information bits to low variable nodes and low information bits to high variable nodes, the high information bits having high importance priorities and the low information bits having low importance priorities from among the information bits, wherein the low variable nodes are variable nodes having low error probability values and the high variable nodes are variable nodes having high error probability values in a factor graph of the LDPC codes.

In accordance with another aspect of the present invention, there is provided a method for transmitting information bits after coding the information bits with Low Density Priority Check (LDPC) codes having unequal error probability values in a wireless communication system which channel-codes and transmits the information bits. The method comprises the steps of mapping information bits having high importance priorities from among the information bits to variable nodes having low error probability values in a factor graph of the LDPC codes and mapping information bits having low importance priorities from among the information bits to variable nodes having high error probability values in the factor graph of the LDPC codes.

In accordance with another aspect of the present invention, there is provided a method for receiving information bits coded with Low Density Priority Check (LDPC) codes having unequal error probability values in a wireless communication system which channel-codes and transmits the information bits. The method comprises the steps of de-mapping information bits corresponding to a predetermined rule for mapping the information bits having high importance priorities from among the information bits to variable nodes having low error probability values in a factor graph of the LDPC codes and de-mapping information bits corresponding to a predetermined rule for mapping the information bits having low importance priorities from among the information bits to variable nodes having high error probability values in the factor graph of the LDPC codes.

In accordance with another aspect of the present invention, there is provided a method for coding and transmitting data in a wireless communication system which channel-codes and transmits information bits. The method comprises the steps of generating information bits and mapping generated information bits to input nodes of a encoder according to importance priorities of the generated information bits, performing channel coding of mapped information bits in accordance with coding of an unequal low density parity check encoder, signal-mapping channel-coded information bits and modulating mapped signal according to a scheme set in advance in the mobile communication system and transmitting final data output after being modulated.

In accordance with another aspect of the present invention, there is provided a method for decoding received data in a wireless communication system which channel-codes and transmits information bits. The method comprises the steps of receiving a signal transmitted from a transmission side through a channel and decoding the received signal according to a demodulation scheme corresponding to a modulation scheme which was initially applied to the signal, inverse-mapping decoded data and performing channel-decoding by mapping inverse-mapped signals to Low Density Priority Check (LDPC) codes having unequal error probability values according to importance priorities of the inverse-mapped signals and outputting channel-decoded data as a final output data.

In accordance with another aspect of the present invention, there is provided a method for mapping information bits to Low Density Priority Check (LDPC) codes according to importance priorities of the transmission bits in a wireless communication system which channel-codes and transmits the information bits. The method comprises the steps of (a) arranging variable nodes in a factor graph of a parity check matrix of the LDPC codes according to a sequence in which variables a highest degree precede any other variable, and setting a first sequence index for assignment of information bits having high priorities; (b) establishing a variable node set including variable nodes having a highest degree from among unassigned variable nodes and confirming elements of the variable node set; (c) assigning a single variable node to an information bit when the variable node set includes the single variable node, and setting a second sequence index for assignment of information bits included in the variable node set when the variable node set includes multiple elements; and (d) determining variable nodes having the highest degree according to the second sequence index, and assigning information bits to variable nodes having a largest cycle from among variable nodes having a same degree.

In accordance with another aspect of the present invention, there is provided an apparatus for decoding Low Density Priority Check (LDPC) codes having unequal error probability values in a wireless communication system which channel-codes and transmits information bits. The apparatus comprises a variable node decoder for connecting variable nodes to columns of a check matrix of the LDPC codes according to weights of the columns, thereby obtaining probability values; a first adder for subtracting a signal generated in previous decoding from an output signal of the variable node decoder; a deinterleaver for deinterleaving an output signal of the first adder in accordance with the parity check matrix; a check node decoder for connecting check nodes to the columns of the check matrix of the LDPC codes according to weights of the columns, thereby obtaining probability values of signals output from the deinterleaver; a second adder for subtracting an output signal of the deinterleaver from an output signal of the check node decoder; an interleaver for interleaving an output signal of the second adder in accordance with the parity check matrix; a controller for generating the parity check matrix and controlling deinterleaving and interleaving in accordance with the parity check matrix; and a memory for storing the parity check matrix of the LDPC codes having unequal error probability values for coding or decoding the information bits according to importance priorities of the information bits, wherein the deinterleaver is controlled by the controller based on the parity check matrix stored in the memory.

## BRIEF DESCRIPTION OF THE DRAWINGS

The above and other objects, features and advantages of the present invention will be more apparent from the following detailed description taken in conjunction with the accompanying drawings, in which:

FIG 1 illustrates a typical parity check matrix of an (8, 2, 4) LDPC code;
FIG. 2 illustrates a factor graph of the parity check matrix of an (8, 2, 4) LDPC code shown in FIG. 1;
FIG 3 illustrates a factor graph of an LDPC code having unequal error probability values according to an embodiment of the present invention;
FIG 4 is a flowchart of a process for mapping transmission bits to LDPC codes according to importance priorities of the bits according to an embodiment of the present invention;
FIG 5 is a block diagram of a data transmission apparatus according to an embodiment of the present invention;
FIG. 6 is a block diagram of a data reception apparatus according to an embodiment of the present invention;
FIG. 7 is a flowchart of a data transmission method according to an embodiment of the present invention;
FIG. 8 is a flowchart of a data reception method according to an embodiment of the present invention; and
FIG. 9 is a block diagram showing an internal structure of a decoder for unequal block LDPC codes according to an embodiment of the present invention.

## DETAILED DESCRIPTION OF THE PREFERRED EMBODIMENT

Hereinafter, preferred embodiments of the present invention will be described with reference to the accompanying drawings. In the following description, a detailed description of known functions and configurations incorporated herein will be omitted when it may make the subject matter of the present invention unclear.

The present invention employs Low Density Parity Check (LDPC) codes in order to realize codes having unequal error probability values, thereby solving the problem of the prior art in that the conventional linear block codes cannot have unequal error probability values.

Therefore, the present invention proposes unequal LDPC codes for mapping bits requiring a high reliability to a node having a low error probability value and bits requiring a low reliability to a node having a high error probability value in a factor graph of the LDPC code.

Meanwhile, the error probability value of each nodes in a factor graph of the LDPC code depends on a cycle and a degree of each nodes. Specifically, the longer the cycle of each nodes arc, the lower the error probability value is. Also, the higher the degree of each node is, the lower the error probability value is.

In general, in the LDPC code, the higher the degree of a variable node is, the higher the reliability is. Therefore, this property can be used to design codes having unequal error probability values by assigning a higher degree to a bit having a higher importance priority from among data having bits with different degrees of importance.

Further, the LDPC codes not only can be used in iterative decoding but also may have different error probability values for bits. Therefore, the LDPC codes are proper for design of codes having unequal error probability values.

Hereinafter, the LDPC code will be briefly described to assist in the understanding of the present invention.

The LDPC code can be decoded using an iterative decoding algorithm based on a sum-product algorithm of a factor graph. Because a decoder for the LDPC code uses the sum-product algorithm-based iterative decoding algorithm, it is less complex than a decoder for the turbo code. In addition, the decoder for the LDPC code is easy to implement with a parallel processing decoder, compared with the decoder for the turbo code.

When the LDPC code is expressed with a factor graph, cycles exist on the factor graph of the LDPC code. It is well known that iterative decoding on the factor graph of the LDPC code where cycles exist is less than optimized (sub-optimal). Also, it has been experimentally proved that the LDPC code has excellent performance through iterative decoding. However, when many cycles with a short length exist on the factor graph of the LDPC code, the LDPC code suffers from performance degradation. Therefore, studies are continuously being conducted to develop a technique for designing an LDPC code such that no cycles with a short lengths exist on the factor graph of the LDPC code.

A coding process of the LDPC code has evolved into a coding process that uses a parity check matrix having a low weight density due to a characteristic of a generating matrix generally having a high weight density. The "weight" represents an element having a non-zero value from among the elements constituting the generating matrix and parity check matrix. In particular, if a partial matrix corresponding to a parity in the parity check matrix has a regular format, more efficient coding is possible.

The LDPC code is proposed by Gallager, and one LDPC code is defined by a parity check matrix in which major elements have a value of 0 and minor elements except the elements having the value of 0 have a value of 1.

To be more specific, the LDPC coding scheme is a block code coding scheme which codes transmission data I by operating on the data I with a generative matrix G. Here, when the coded data is put as C, the coded data C is expressed as Equation 1 below.

$$I \cdot G = C \qquad \text{Eq.(1)}$$

When the coded data C is decoded, the coded data C is operated with a parity check matrix H, and it is determined that there is no error when the operation results of the parity check matrix for all C as shown in Equation 2 below.

$$H \cdot C = 0, \ \forall C \qquad \text{Eq.(2)}$$

Therefore, both the LDPC code and the complexity of operation for the LDPC can be defined by the parity check matrix H.

For example, an (N, j, k) LDPC code is a linear block code having a block length N, and is defined by a sparse parity check matrix in which each column has j elements having a value of 1, each row has k elements having a value of 1, and all of the elements except for the elements having the value of 1 have a value of 0.

An LDPC code in which a weight value of each column in the parity check matrix is fixed to 'j' and a weight value of each row in the parity check matrix is fixed to 'k' as stated above, is called a "regular LDPC code." Herein, the weight value represents the number of weights. Unlike the regular LDPC code, an LDPC code in which the weight value of each column in the parity check matrix and the weight value of each row in the parity check matrix are not fixed is called an "irregular LDPC code." It is generally known that the irregular LDPC code is superior in performance to the regular LDPC code. However, in the case of the irregular LDPC code, because the weight value of each column and the weight value of each row in a parity chock matrix are not fixed, i.e. are irregular, the weight value of each column in the parity check matrix and the weight value of each row in the parity check matrix must be properly adjusted in order to guarantee the excellent performance.

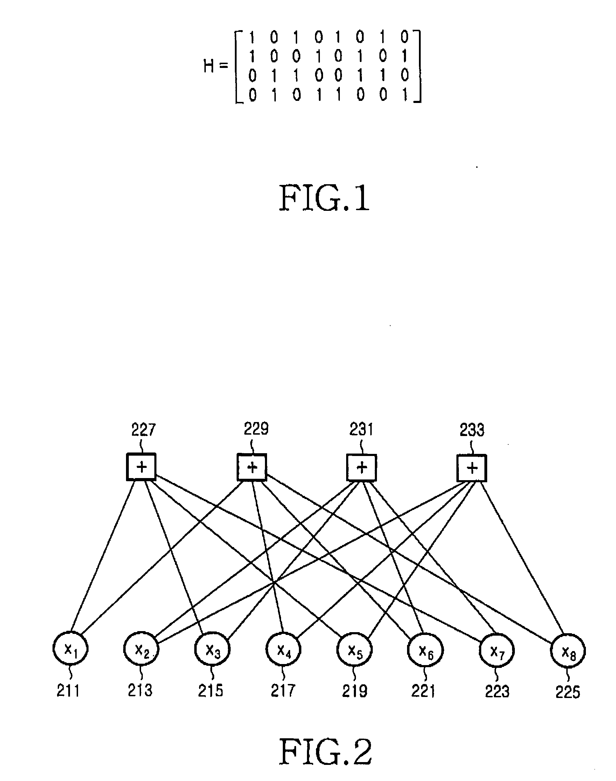

With reference to FIGs. 1 and 2, a description will now be made of a parity check matrix of an (8, 2, 4) LDPC code as an example of an (N, j, k) LDPC code.

FIG 1 is a diagram illustrating a parity check matrix of a general (8, 2, 4) LDPC code.

Referring to FIG 1, a parity check matrix H of the (8, 2, 4) LDPC code is comprised of 8 columns and 4 rows, wherein a weight value of each column is fixed to 2 and a weight value of each row is fixed to 4. Because the weight value of each column and the weight value of each row in the parity check matrix are regular as stated above, the (8, 2, 4) LDPC code illustrated in FIG 1 becomes a regular LDPC code.

A factor graph of the (8, 2, 4) LDPC code described in connection with FIG. 1 will be described herein below with reference to FIG 2.

FIG 2 is a diagram illustrating a factor graph of the (8, 2, 4) LDPC code of FIG 1.

Referring to FIG. 2, a factor graph of the (8, 2, 4) LDPC code is comprised of 8 variable nodes of $x_1$ 211, $x_2$ 213, $x_3$ 215, $x_4$ 217, $x_5$ 219, $x_6$ 221, $x_7$ 223 and $x_8$ 225, and 4 check nodes 227, 229, 231 and 233. When an element having a weight, i.e., a value of 1, exists at a point where an $i^{th}$ row and a $j^{th}$ column of the parity check matrix of the (8, 2, 4) LDPC code cross each other, a branch is formed between a variable node $x_j$ and a $i^{th}$ check node.

Because the parity check matrix of the LDPC code has a small weight value as described above, it is possible to perform the decoding through an iterative decoding process even in a block code having a relatively long length, that exhibits a performance approximating a capacity limit of a Shannon channel such as a turbo code while continuously increasing a block length of the block code. It has been proven that an iterative decoding process of an LDPC code using a flow transfer technique is almost approximate to an iterative decoding process of a turbo code in performance.

In order to generate a high-performance LDPC code, the following conditions should be satisfied.

## (1) Cycles on a factor graph of an LDPC code should be considered.

The "cycle" refers to a loop formed by the edges connecting the variable nodes to the check nodes in a factor graph of an LDPC code, and a length of the cycle is defined as the number of edges constituting the loop. A cycle being long in length means that the number of edges connecting the variable nodes to the check nodes constituting the loop in the factor graph of the LDPC code is large. In contrast, a cycle being short in length means that the number of edges connecting the variable nodes to the check nodes constituting the loop in the factor graph of the LDPC code is small.

As cycles in the factor graph of the LDPC code become longer, the performance efficiency of the LDPC code increases, for the following reasons. That is, when long cycles are generated in the factor graph of the LDPC code, it is possible to prevent the performance degradation such as an error floor occurring when too many cycles with a short length exist on the factor graph of the LDPC code,

## (2) Bits having a higher degree have a better performance on a factor graph of the LDPC code.

Generally, bits having a higher degree have a better performance on a factor graph of the LDPC code because the bits having a higher degree can be restored through iterative decoding by other bits connected through edges. The "degree" refers to the number of edges connected to the variable nodes and the check nodes in the factor graph of the LDPC code. Further, "degree distribution" on a factor graph of an LDPC code refers to a ratio of the number of nodes having a particular degree to the total number of nodes.

Therefore, the present invention proposes a method for effectively coding and decoding information having bits of different degrees of importance (such as control information) by using the difference between error probability values of the nodes in the unequal LDPC code as described above.

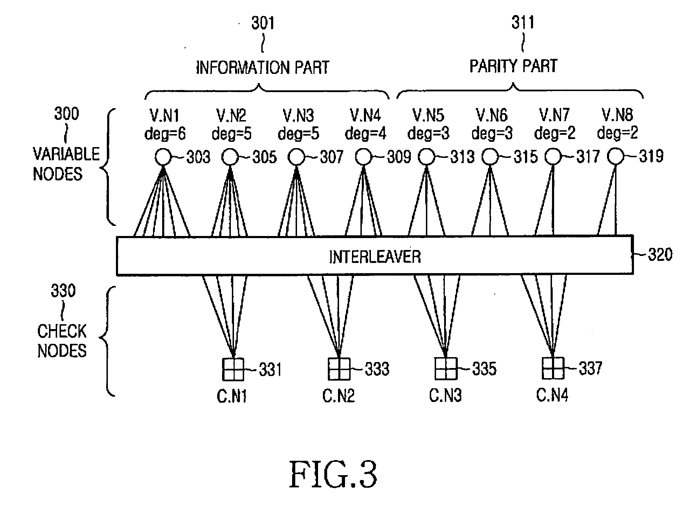

FIG. 3 is a diagram illustrating a factor graph of an LDPC code having unequal error probability values according to an embodiment of the present invention. FIG 3 shows an LDPC code having a coding rate of 1/2, which receives four information bits and generates eight coded bits.

Referring to FIG. 3, the factor graph of an LDPC code having unequal error probability values according to an embodiment of the present invention can be expressed by variable nodes 300, check nodes 330 and an interleaver 320. For example, the factor graph may include eight variable nodes of V.N1 to V.N8 303 through 319, respectively, and four check nodes of C,N1 to C. N4 331 through 337, respectively. The interleaver 320 interconnects the variable nodes 300 and the check nodes 330 according to determined LDPC codes.

Meanwhile, from among the variable nodes 300, V.N1 303, V.N2 305, V.N3 307 and V.N4 309 are variable nodes of an information part 301 in which information bits are mapped and operated and V.N5 313, V. N6 315, V.N7 317 and V.N8 319 are variable nodes of a parity part 311 in which parity bits generated by mapping the information bits are mapped and operated.

The lines connected to each variable node represents edges connected to multiple check nodes and the number of edges connected to each node implies the degree of the node. That is, V.N1 303 has a degree of 6 because 6 edges are connected to V.N1 303, and V.N2 305 has a degree of 5 because 5 edges are connected to V.N2 305. As described above, the higher the degree is, the smaller the error probability value of the information bits mapped to the corresponding node is.

Therefore, in the present invention, coding is performed reflecting degrees of importance of information bits according to the degree of each node, that is, according to the number of the edges connected to each node. In other words, from among the information bits to be coded and transmitted, bits having a high weight are mapped to the nodes of the high degree and bits having a low weight are mapped to the nodes of the low degree. Further, between nodes having the same degree, bits having a higher weight are mapped to nodes having a larger cycle because the nodes having a larger cycle have a lower error probability value.

Hereinafter, a method of mapping bits according to one embodiment of the present invention will be described in detail with reference to FIG 3.

First, for assignment of bits with a highest priority, {V.N1} is obtained as a set of variable nodes having the highest degree. Here, the obtained set includes only one clement, the bit having the highest priority (i.e., the highest weight) is assigned to node V.N1 303.

Next, for assignment of bits with a second-highest priority, a set of variable nodes having the highest degree from among the unassigned variable nodes are obtained. Because the highest degree of the variable nodes excluding the already-assigned variable node is 5, {V.N2, V.N3} is obtained as a set of variable nodes having the degree of 5. The obtained set includes 2 elements. In this case, since the two variable nodes have the same degree, cycles of the two variable nodes are compared and a variable node having the larger cycle is selected. If V.N3 307 has a larger cycle than that of V.N2 305, the bit having the second-highest priority is assigned to V.N3 307 and the bit having the third-highest priority is assigned to V.N2 305. In contrast, if V.N3 307 has a smaller cycle than that of V.N2 305, the bit having the second-highest priority is assigned to V.N2 305 and the bit having the third-highest priority is assigned to V. N3 307.

Next, for assignment of bits with a fourth-highest priority, V.N4 309 having the degree of 4 is selected. In conclusion, the bit having the highest priority is mapped to V.N1 303, the bit having the second-highest priority is mapped to V.N3 307, the bit having the third-highest priority is mapped to V.N2 305, and the bit having the fourth-highest priority is mapped to V.N4 309. Meanwhile, parity bits are assigned to the other variable nodes.

Here, the method of mapping the information bits to the variable nodes includes a method of performing the mapping after rearranging the information bits according to the mapping sequence described above and a method of interchanging columns of a parity check matrix in the LDPC code while fixing the inputted information bits.

For example, when the transmitted information bits have degrees of importance decreasing as it goes from the Most Significant Bit (MSB) to the Least Significant Bit (LSB) as shown in Table 1, the second column and the third column of the parity check bit may be replaced to perform an effective mapping. Instead, the second bits and the third bits of the inputted information bits may be replaced to perform the effective mapping.

Meanwhile, in the design of the LDPC codes, the entire code performance can be improved by improving a minimum cycle through a proper design of the interleaver 320.

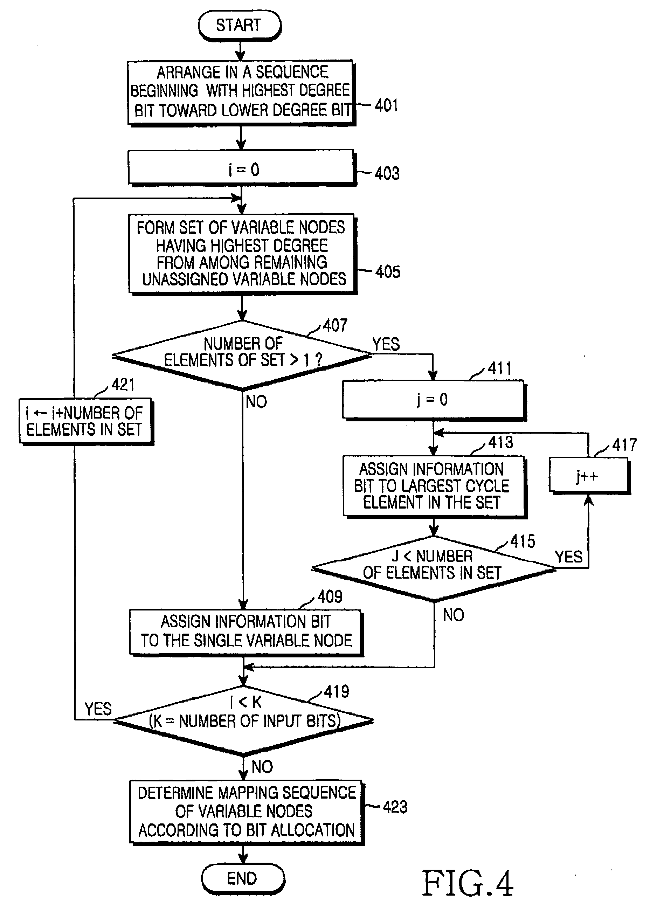

Hereinafter, a method of mapping the LDPC codes and the information bits according to the embodiment of the present invention as described above with reference to FIG 3 will be generalized and described with reference to FIG 4.

FIG. 4 is a flowchart of a process for mapping transmission bits to LDPC codes according to importance priorities of the bits.

Referring to FIG 4, a factor graph according to a parity check matrix of a given LDPC code is first arranged in a sequence in which a bit having a highest degree precedes any other bit step 401. Here, index i which indicates a turn for assigning a corresponding bit according to the sequence in which a bit having a highest degree precedes any other bit is set to be 0 step 403. Then, a set of variable nodes having the highest degree from among the remaining unassigned variable nodes is obtained step 405. Then, the number of elements contained in the obtained variable node set is examined step 407.

As a result of the determination resulting from step 407, when the variable node set obtained in step 405 includes a single element, the information bit is assigned to the single variable node in step 409. In contrast, as a result of the determination resulting from step 407, when the variable node set obtained in step 405 includes multiple elements, a process as follows is performed in order to determine priorities of the variable nodes in the set having the same degree.

First, in order to assign bits belonging to the set, a sequence index j is set to be 0 step 411. Thereafter, a node having the largest cycle from among the variable nodes of highest degree is selected and assigned an information bit in step 413. Then, the sequence index j is compared with the number of the elements in the set in step 415. When the sequence index j is smaller than the number of the elements in the set, one is added to the sequence index j in step 417. Then, the above process is repeated, until all variable nodes of the set are assigned information bits.

Meanwhile, when all variable nodes of the set have been assigned to the information bits through the comparison in step 415, the sequence index i is compared with the number K of the input bits in step 419. Here, if the sequence index is smaller than the number K of the input bits, the number of the element in the set is added to the sequence index i in step 421. Then, the process is repeated over again from step 405. Finally, when assignment of all the input bits has been completed, the variable nodes in the parity cheek matrix are arranged according to the bit assignment and the mapping sequence is determined in step 423. That is, the sequence of the variable nodes is determined according to the sequence of the information bits to be transmitted.

Here, the method of mapping the transmission bits to the LDPC codes according to their degrees of importance includes, as described above, a method of performing the mapping after rearranging the information bits according to the mapping sequence while fixing the LDPC codes and a method of interchanging columns of a parity check matrix in the LDPC code while fixing the inputted information bits.

Here, by performing the process described above, information bits to be transmitted can be mapped to the LDPC codes according to their degrees of importance or priorities. Further, the mapping scheme is determined by the cycle of each variable node and the edge number (i.e., degree) of each variable node determining an error probability value of the LDPC code. That is, from among the information bits to be transmitted, bits having a high weight are mapped so as to be coded by variable nodes having a low error probability value from among the variable modes in the factor graph of the LDPC code while bits having a low weight are mapped so as to be coded by variable nodes having a high error probability value from among the variable modes in the factor graph of the LDPC code.

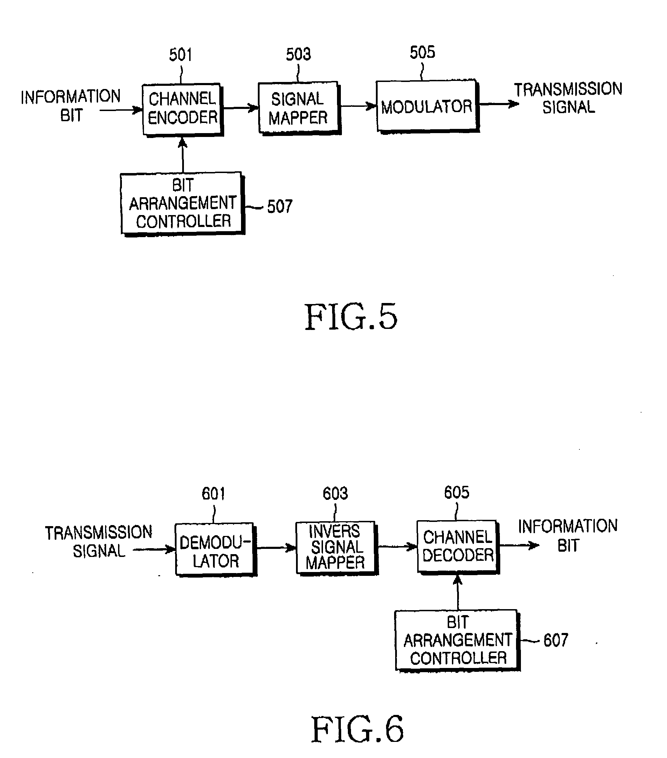

Hereinafter, an apparatus and a method for transmitting/receiving data based on the LDPC coding scheme according to the embodiment of the present invention described above with reference to FIGs. 5 through 8.

First, a data transmission apparatus and a data reception apparatus will be described with reference to FIGs. 5 and 6.

FIG. 5 is a block diagram of a data transmission apparatus according to an embodiment of the present invention.

Referring to FIG. 5, similar to a typical transmitter in a mobile communication system, a data transmission apparatus according to the embodiment of the present invention includes a channel encoder 501, a signal mapper 503 and a modulator 505.

First, information bits to be transmitted are input to the channel encoder 501. Then, the channel encoder 501 codes the input information bits into coded bits. Here, the coding process is necessary in order to add additional information to information bits, thereby correcting any errors which may occur in a channel and achieving a communication with a higher reliability. The channel encoder 501 can be a convolutional encoder, a turbo encoder or an LDPC encoder in a typical mobile communication system.

The channel encoder according to the embodiment of the present invention may be an unequal LDPC encoder and the information bits requiring unequal error probability values from among the input information bits can be coded according to the method according to the embodiment of the present invention. That is, the unequal LDPC encoder according to the embodiment of the present invention maps the input information bits to the variable nodes in the factor graph of the LDPC code while applying different error probability values to the information bits according to the importance priorities of the information bits.

The data transmission apparatus according to the embodiment of the present invention further includes a bit arrangement controller 507. The bit arrangement controller 507 can control the information bits to be the LDPC codes arranged according to their degrees of importance. However, when the transmitted information bits with a sequence of the degrees of importance determined in advance are input to the channel encoder 501, the bit arrangement controller 507 is unnecessary and the LDPC codes may be mapped according to the predetermined sequence of the degrees of importance.

Next, coded bits which are output data of the channel encoder 501 are mapped by the signal mapper 503. Here, the signal mapper 503 may map the input bit symbols in various ways according to the modulation schemes employed in the communication system. For example, when a Binary Phase Shift Keying (BPSK) scheme is used for the modulation scheme, an input bit of 0 input to the signal mapper 503 is mapped into 1 and an input bit of 1 is mapped into -1.

A mapped signal is modulated into a transmission signal by the modulator 505. The modulator 505 is a device capable of receiving a signal from the signal mapper 503 and transmitting the signal to a transmission link, that is, converting the signal into an electric signal of a modified type. The modulation schemes employable by the modulator 505 include a BPSK scheme, a Quadrature Phase Shift Keying (QPSK) scheme, an 8 Phase Shift Keying (8PSK) scheme, a 16 Quadrature Amplitude Modulation (16QAM) scheme, and a 64QAM scheme. Such modulation schemes have no direct relation to the present invention, so detailed description of them will be omitted here.

The data transmitted by the transmission apparatus as described above with reference to FIG. 5 can be received by a reception apparatus as shown in FIG 6 according to an order which is the reverse of the aforementioned order.

FIG. 6 is a block diagram of a data reception apparatus according to an embodiment of the present invention.

Referring to FIG. 6, similar to a typical receiver in a mobile communication system, a data reception apparatus according to the embodiment of the present invention includes a demodulator 601, an inverse signal mapper 603, and a channel decoder 605.

First, a signal received by an antenna (not shown) through a wireless channel is input to the demodulator 601 after being radio-processed by a radio-processor (not shown). The demodulator 601 demodulates the received signal according to a demodulation scheme corresponding to the modulation scheme of the modulator 505 in the data transmission apparatus of FIG. 5. For example, data modulated according to a BPSK scheme is demodulated according to a demodulation scheme corresponding to the BPSK scheme.

The output signal from the demodulator 601 corresponds to an element of the mapped signal before being modulated by the modulator 505 in the transmission apparatus of FIG 5. In other words, the signal modulated for transmission in the transmission apparatus is restored to the signal before being modulated.

Meanwhile, the output data of the demodulator 601 is estimated and converted to data before passing the signal mapper 503 of FIG. 5 by the inverse signal mapper 603. That is, the inverse signal mapper 603 is a unit corresponding to the signal mapper 503 of FIG 5 and finds estimation values for bits before passing the signal mapper 503 in order to convert the output data of the demodulator 601 to an input data of the channel decoder 605.

Next, the output data of the inverse signal mapper 603 is input to the channel decoder 605. Here, the channel decoder 605 performs a process inverse to that of the channel encoder 501 of FIG. 5. Here, the channel decoder 605 estimates and outputs the transmitted information bits based on the output data of the inverse signal mapper 603.

Meanwhile, various types of channel decoders according to the structures of the channel encoder 501 of FIG 5 may be employed as the channel decoder 605. The channel decoder 605 employed in the embodiment of the present invention is an LDPC decoder having unequal error probability values.

That is, since the information bits transmitted from the channel encoder 501 of FIG. 5 are mapped to the variable nodes of the unequal LDPC encoder in consideration of the importance priorities of the information bits, the channel decoder 605 for decoding the received signal is preferably an unequal LDPC decoder corresponding to the LDPC encoder used as the channel encoder 501.

Meanwhile, the data reception apparatus can include an optional bit arrangement controller 607 equal to the bit arrangement controller 507 in the transmission apparatus. The bit arrangement controller 607 controls the channel decoder 605 and mapping information in relation to the method of mapping the unequal LDPC code according to the importance priority of the information bits.

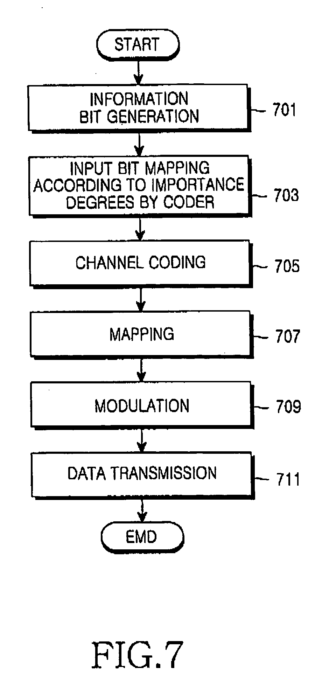

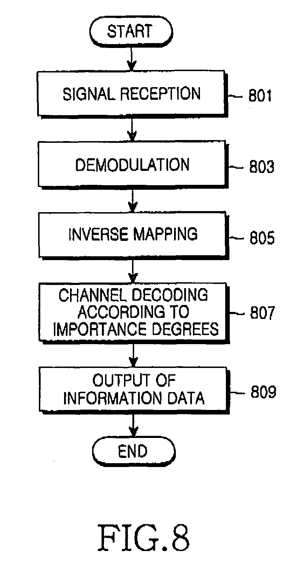

Hereinafter, a data transmission method and a data reception method will be described with reference to FIGs. 7 and 8.

FIG. 7 is a flowchart of a data transmission method according to an embodiment of the present invention.

Referring to FIG. 7, first, information bits to be transmitted are generated in step 701. The information bits are mapped to input nodes of the encoder according to the importance priorities of the information bits step 703. Then, channel coding is performed by the unequal LDPC encoder corresponding to the mapping scheme in step 705. The channel-coded information bits are signal-mapped by the signal mapper in step 707 and the signal-mapped signal is input to the modulator. The signal input to the modulator is modulated according to a modulation scheme corresponding to a predetermined system condition in step 709 and the final data is transmitted to the reception side in step 711.

The data transmitted according to the data transmission method as described above with reference to FIG. 7 can be received according to a data reception method as described below with reference to FIG. 8. The data reception method is reverse to the data transmission method described above.

FIG 8 is a flowchart of a data reception method according to an embodiment of the present invention.

Referring to FIG 8, a signal from a channel is received in step 801 and the received signal is demodulated into the data corresponding to that before the modulation in step 803. Here, the demodulation employs a demodulation scheme corresponding to the modulation scheme of the transmission side. Then, the demodulated data is inverse-mapped by the inverse signal mapper in step 805. Here, the inverse signal mapper performs estimation for the data before the signal mapping.

Next, the output value inverse-mapped by the inverse signal mapper is input to the decoder which decodes the value into the data before the encoding according to its degree of importance in step 807. Here, the decoding employs a decoding scheme corresponding to the encoding scheme described above with reference to FIG. 7. Specifically, the decoding according to the embodiment of the present invention uses LDPC codes having unequal error probability values. Finally, the decoded signal is output as information data in step 809.

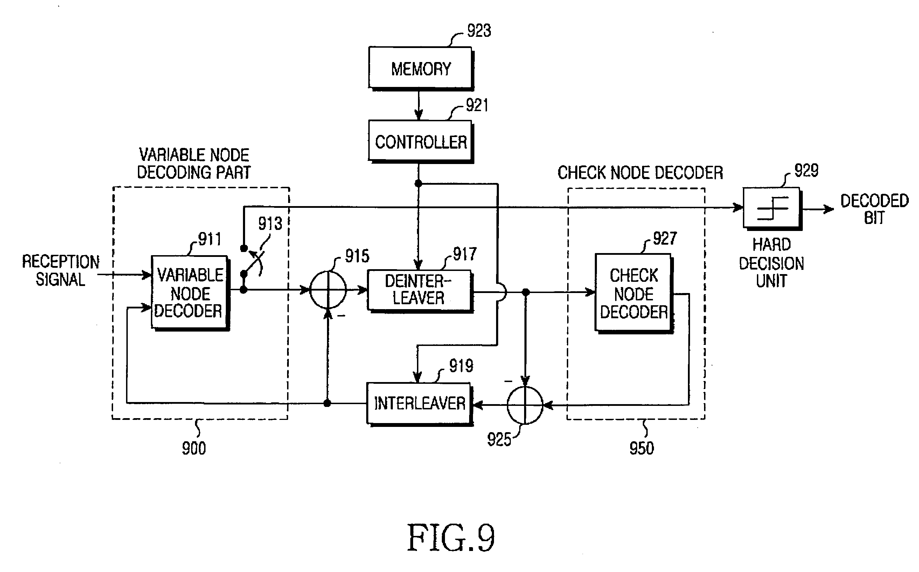

Hereinafter, a process of decoding unequal LDPC codes according to the embodiment of the present invention by the unequal LDPC encoder described above with reference to FIG. 9 will be described.

FIG. 9 is a block diagram showing an internal structure of a decoder for unequal block LDPC codes according to the embodiment of the present invention.

Referring to FIG. 9, the decoder for the unequal block LDPC codes includes a variable node decoding part 900, an adder 915, a deinterleaver 917, an interleaver 919, a controller 921, a memory 923, an adder 925, a check node decoding part 950, and a hard decision unit 929. Further, the variable node decoding part 900 includes a variable node decoder 911 and a switch 913, and the check node decoding part 950 includes a check node decoder 927.

First, a signal received through a wireless channel is input to the variable node decoder 911 of the variable node decoding part 900. The variable node decoder 911 calculates probability values of the input signals and updates and outputs the calculated probability values to the switch 913 and the adder 915. Here, the variable node decoder 911 connects the variable nodes in accordance with a parity check matrix set in advance in the decoder for the block LDPC codes and performs the update operation having the same number of input values and output values as the number of values '1' connected to each of the variable nodes. The number of values '1' connected to each of the variable nodes is equal to the weight of each of columns of the parity check matrix. Therefore, the variable node decoder 911 performs different internal operations according to the weights of the columns of the parity check matrix.

The adder 915 receives the signal output from the variable node decoder 911 and a signal output from the interleaver 919 in the previous process of iteration decoding. Also, the adder 915 subtracts the output signal of the interleaver 919 in the previous process of iteration decoding from the output signal of the variable node decoder 911 and outputs the subtracted signal to the deinterleaver 917. Here, when the decoding is the first decoding, it is naturally assumed that the output signal of the deinterleaver 917 is considered as 0.

The deinterleaver 917 receives the output signal of the adder 915, deinterleaves the signal according to a scheme set in advance, and outputs it to the adder 925 and the check node decoder 927. Here, the deinterleaver 917 has an internal structure corresponding to the parity check matrix. It is because the output values for the input values of the interleaver 919 corresponding to the deinterleaver 917 are different according to the positions of the elements having the value '1' in the parity check matrix.

Meanwhile, the adder 925 receives the signal output from the check node decoder 927 in the previous process of iteration decoding and a signal output from the deinterleaver 917. Also, the adder 925 subtracts the output signal of the deinterleaver 917 from the output signal of the check node decoder 927 in the previous process of iteration decoding and outputs the subtracted signal to the interleaver 919. Here, the check node decoder 927 connects the check nodes in accordance with the parity check matrix set in advance in the decoder for the block LDPC codes and performs the update operation having the same number of input values and output values as the number of values '1' connected to each of the check nodes. The number of values '1' connected to each of the check nodes is equal to the weight of each of the rows of the parity check matrix. Therefore, the check node decoder 927 performs different internal operations according to the weights of the rows of the parity check matrix.

Next, the interleaver 919 interleaves the output signal of the adder 925 according to a scheme set in advance under the control of the controller 921 and outputs the interleaved signal to the adder 915 and the variable node decoder 911. Here, the controller 921 reads information in relation to the interleaving scheme stored in the memory 923 according to the parity check matrix designed according to the present invention and controls the interleaving by the interleaver 919. Further, when the decoding is the first decoding, it is natural that the output signal of the deinterleaver 917 must be considered as 0.

Here, the parity check matrix for codes having unequal error probability values according to the present invention are stored in advance in the memory as described above and the deinterleaver follows the scheme set in the controller based on the parity check matrix stored in the memory.

By repeatedly performing the above process, highly reliable decoding without error can be achieved. After the repetitive decoding is performed predetermined times, the switch 913 switches off the connection between the variable node decoder 911 and the adder 915 and switches on the connection between the variable node decoder 911 and the hard decision unit 929, so that the signal output from the variable node decoder 911 can be output to the hard decision unit 929. The hard decision unit 929 hard-decides the signal output from the variable node decoder 911 and outputs the result of the hard decision, which is the resultant decoded value.

Meanwhile, the unequal LDPC codes according to the embodiment of the present invention are stored in the memory 923. Here, the stored unequal LDPC codes are codes set for the LDPC coding and decoding in consideration of the degrees of importance of the transmitted information bits. Therefore, when the sequence for the degrees of importance of the transmitted information bits changes, the columns of the LDPC codes may be interchanged or the mapping sequence may be changed according to the present invention.

In a mobile communication system according to the present invention as described above, codes having unequal error probability values are designed using LDPC codes having various degrees and are used in coding information having different degrees of importance such as control information, thereby improving the performance of the system.

While the invention has been shown and described with reference to certain preferred embodiments thereof, it will be understood by those skilled in the art that various changes in form and details may be made therein without departing from the spirit and scope of the invention as defined by the appended claims.

## Claims

1. An apparatus for transmitting information bits after coding the information bits with. Low Density Parity Check (LDPC) codes having unequal error probability values in a wireless communication system which channel-codes and transmits the information bits, the apparatus comprising:

   a LDPC encoder for mapping high information bits to low variable nodes and low information bits to high variable nodes, the high information bits haying high importance priorities and the low information bits having low importance priorities from among the information bits, wherein the low variable nodes are variable nodes having low error probability values and the high variable nodes are variable nodes having high error probability values in a factor graph of the LDPC codes.

2. The apparatus as claimed in claim 1, wherein the error probability value of each of the variable nodes is determined by a degree of each of the variable nodes.

3. The apparatus as claimed in claim 2, wherein the higher the degree of each of the variable nodes, the smaller the error probability value of each of the variable nodes.

4. The apparatus as claimed in claim 1, wherein the error probability value of each of the variable nodes is determined by a cycle of each of the variable nodes.

5. The apparatus as claimed in claim 4, wherein the longer the cycle of each of the variable nodes , the smaller the error probability value of each of the variable nodes.

6. The apparatus as claimed in claim 1, further comprising a modulator for modulating and transmitting the information bits mapped and output according to the importance priorities.

7. The apparatus as claimed in claim 1, wherein, when the information bits are mapped according to the importance priorities, columns of a parity check matrix of the LDPC codes are interchanged.

8. The apparatus as claimed in claim 1, wherein, when the information bits are mapped according to the importance priorities, the LDPC codes are fixed and the information bits are rearranged according to the importance priorities of the information bits.

9. The apparatus as claimed in claim 1, further comprising a bit arrangement controller for controlling the mapping such that the information bits are mapped to the LDPC codes according to the importance priorities of the information bits.

10. An apparatus for receiving information bits coded with Low Density Priority Check (LDPC) codes having unequal error probability values in a wireless communication system which channel-codes and transmits the information bits, the apparatus comprising:

a LDPC decoder for de-mapping corresponding to a predetermined encoder for mapping high information bits to low variable nodes and low information bits to high variable nodes, the high information bits having high importance priorities and the low information bits having low importance priorities from among the information bits, wherein the low variable nodes are variable nodes having low error probability values and the high variable nodes are variable nodes having high error probability values in a factor graph of the LDPC codes.

11. The apparatus as claimed in claim 10, wherein the error probability value of each of the variable nodes is determined by a degree of each of the variable nodes.

12. The apparatus as claimed in claim 11, wherein the higher the degree of each of the variable nodes, the smaller the error probability value of each of the variable nodes.

13. The apparatus as claimed in claim 10, wherein the error probability value of each of the variable nodes is determined by a a cycle of each of the variable nodes.

14. The apparatus as claimed in claim 13, wherein the longer the cycle of each of the variable nodes, the smaller the error probability value of each of the variable nodes.

15. The apparatus as claimed in claim 10, further comprising a demodulator for demodulating the information bits according to a demodulation scheme corresponding to a modulation scheme of a transmission side transmitted the information bits.

16. The apparatus as claimed in claim 10, wherein, when the information bits are mapped according to the importance priorities, columns of a parity check matrix of the LDPC codes are interchanged.

17. The apparatus as claimed in claim 10, wherein, when the information bits are mapped according to the importance priorities, the LDPC codes are fixed and the information bits are rearranged according to the importance priorities of the information bits.

18. The apparatus as claimed in claim 10, further comprising a bit arrangement controller for controlling the mapping such that the information bits are mapped to the LDPC codes according to the importance priorities of the information bits.

19. A method for transmitting information bits after coding the information bits with Low Density Priority Check (LDPC) codes having unequal error probability values in a wireless communication system which channel-codes and transmits the information bits, the method comprising the steps of:

mapping information bits having high importance priorities from among the information bits to variable nodes having low error probability values in a factor graph of the LDPC codes; and mapping information bits having low importance priorities from among the information bits to variable nodes having high error probability values in the factor graph of the LDPC codes.

20. The method as claimed in claim 19, wherein the error probability value of each of the variable nodes is determined by a degree of each of the variable nodes.

21. The method as claimed in claim 20, wherein the higher the degree of each of the variable nodes, the smaller the error probability value of each of the variable nodes.

22. The method as claimed in claim 19, wherein the error probability value of each of the variable nodes is determined by a cycle of each of the variable nodes.

23. The method as claimed in claim 22, wherein the longer the cycle of each oftbe variable nodes, the smaller the error probability value of each of the variable nodes.

24. The method as claimed in claim 19, further comprising a step of modulating and transmitting the information bits mapped and output according to the importance priorities.

25. The method as claimed in claim 19, wherein, when the information bits are mapped according to the importance priorities, columns of a parity check matrix of the LDPC codes are interchanged.

26. The method as claimed in claim 19, wherein, when the information bits are mapped according to the importance priorities, the LDPC codes are fixed and the information bits are rearranged according to the importance priorities of the information bits.

27. The method as claimed in claim 19, further comprising a step of controlling the mapping such that the information bits are mapped to the LDPC codes according to the importance priorities of the information bits.

28. A method for receiving information bits coded with Low Density Priority Check (LDPC) codes having unequal error probability values in a wireless communication system which channel-codes and transmits the information bits, the method comprising the steps of:

de-mapping information bits corresponding to a predetermined rule for mapping the information bits having high importance priorities from among the information bits to variable nodes having low error probability values in a factor graph of the LDPC codes; and de-mapping information bits corresponding to a predetermined rule for mapping the information bits having low importance priorities from among the information bits to variable nodes having high error probability values in the factor graph of the LDPC codes.

29. The method as claimed in claim 28, wherein the error probability value of each of the variable nodes is determined by a degree of each of the variable nodes.

30. The method as claimed in claim 29, wherein the higher the degree of each of the variable nodes, the smaller the error probability value of each of the variable nodes.

31. The method as claimed in claim 28, wherein the error probability value of each of the variable nodes is determined by a cycle of each of the variable nodes.

32. The method as claimed in claim 31, wherein the longer the cycle of each of the variable nodes, the smaller the error probability value of each of the variable nodes.

33. The method as claimed in claim 28, further comprising a step of demodulating the information bits according to a demodulation scheme corresponding to a modulation scheme of a transmission side which transmitted the information bits.

34. The method as claimed in claim 28, wherein, when the information bits are mapped according to the importance priorities, columns of a parity check matrix of the LDPC codes are interchanged.

35. The method as claimed in claim 28, wherein, when the information bits are mapped according to the importance priorities, the LDPC codes are fixed and the information bits are rearranged according to the importance priorities of the information bits.

36. The method as claimed in claim 28, further comprising a step of controlling the mapping such that the information bits are mapped to the LDPC codes according to the importance priorities of the information bits.

37. A method for coding and transmitting data in a wireless communication system which channel-codes and transmits information bits, the method comprising the steps of:

generating information bits and mapping generated information bits to input nodes of a encoder according to importance priorities of the generated information bits;
performing channel coding of mapped information bits in accordance with coding of an unequal low density parity check encoder;
signal-mapping channel-coded information bits and modulating mapped signal according to a scheme set in advance in the mobile communication system; and
transmitting final data output after being modulated.

38. The method as claimed in claim 37, wherein, when the information bits are mapped to input nodes of a encoder according to importance priorities of the information bits, the importance priorities correspond to the error probability values of the variable nodes, each of the error probability values being determined by a degree of each of the variable nodes.

39. The method as claimed in claim 38, wherein the higher the degree of each of the variable nodes, the smaller the error probability value of each of the variable nodes.

40. The method as claimed in claim 37, wherein, when the information bits are mapped to input nodes of a encoder according to importance priorities of the information bits, the importance priorities correspond to the error probability values of the variable nodes, each of the error probability values being determined by cycle of each of the variable nodes.

41. The method as claimed in claim 40, wherein the longer the cycle of each of the variable nodes, the small cr the error probability value of each of the variable nodes.

42. The method as claimed in claim 37, wherein, when the information bits arc mapped according to the importance priorities, columns of a parity check matrix of the LDPC codes are interchanged.

43. The method as claimed in claim 37, wherein, when the information bits are mapped according to the importance priorities, the LDPC codes are fixed and the information bits are rearranged according to the importance priorities of the information bits.

44. The method as claimed in claim 37, further comprising a step of controlling the mapping such that the information bits are mapped to the LDPC codes according to the importance priorities of the information bits.

45. A method for decoding received data in a wireless communication system which channel-codes and transmits information bits, the method comprising the steps of:

receiving a signal transmitted from a transmission side through a channel and decoding the received signal according to a demodulation scheme corresponding to a modulation scheme which was initially applied to the signal;
inverse-mapping decoded data and performing channel-decoding by mapping inverse-mapped signals to Low Density Priority Check (LDPC) codes having unequal error probability values according to importance priorities of the inverse-mapped signals; and
outputting channel-decoded data as a final output data.

46. The method as claimed in claim 45, wherein, when the information bits are mapped according to importance priorities of the information bits, the importance priorities correspond to the error probability values of the variable nodes, each of the error probability values being determined by a degree of each of the variable nodes.

47. The method as claimed in claim 46, wherein the higher the degree of each of the variable nodes , the smaller the error probability value of each of the variable nodes.

48. The method as claimed in claim 45, wherein, when the information bits are mapped according to importance priorities of the information bits, the importance priorities correspond to the error probability values of the variable nodes, each of the error probability values being determined by a cycle of each of the variable nodes.

49. The method as claimed in claim 48, wherein the longer the cycle of each of the variable nodes is, the smaller the error probability value of each of the variable nodes is.

50. The method as claimed in claim 45, wherein, when the information bits are mapped according to the importance priorities, columns of a parity check matrix of the LDPC codes are interchanged.

51. The method as claimed in claim 45, wherein, when the information bits are mapped according to the importance priorities, the LDPC codes are fixed and the information bits are rearranged according to the importance priorities of the information bits.

52. The method as claimed in claim 45, further comprising a step of controlling the mapping such that the information bits are mapped to the LDPC codes according to the importance priorities of the information bits.

53. A method for mapping information bits to Low Density Priority Check (LDPC) codes according to importance priorities of the transmission bits in a wireless communication system which channel-codes and transmits the information bits, the method comprising the steps of:

(a) arranging variable nodes in a factor graph of a parity check matrix of the LDPC codes according to a sequence in which variables a highest degree precede any other variable, and setting a first sequence index for assignment of information bits having high priorities;
(b) establishing a variable node set including variable nodes having a highest degree from among unassigned variable nodes and confirming elements of the variable node set;
(c) assigning a single variable node to an information bit when the variable node set includes the single variable node, and setting a second sequence index for assignment of information bits included in the variable node set when the variable node set includes multiple elements; and
(d) determining variable nodes having the highest degree according to the second sequence index, and assigning information bits to variable nodes having a largest cycle from among variable nodes having a same degree.

54. The method as claimed in claim 53, further comprising a step of comparing the second sequence index with a number of elements in the variable node set, comparing the first sequence index with a number of input bits when all of the variable nodes of the variable node set have been assigned to information bits, and arranging a mapping sequence of the variable nodes of the parity check matrix according to the sequence of the information bits when all of the input information bits have been assigned.

55. The method as claimed in claim 53, further comprising a step of comparing the second sequence index with a number of elements of the variable node set, adding one to the second sequence index when the second sequence index is smaller than the number of elements of the variable node set, and repeating steps a through .e.

56. The method as claimed in claim 53, further comprising a step of comparing the first sequence index with a number of the input bits, adding the number of elements of the variable node set to the first sequence index when the first sequence index is smaller than the number of the input bits, and repeating steps a through e.

57. The method as claimed in claim 53, wherein, when the information bits are mapped according to the importance priorities, the LDPC codes arc fixed and the information bits are rearranged according to the mapping sequence.

58. The method as claimed in claim 53, wherein, when the information bits are mapped according to the importance priorities, the input information bits are fixed and columns of the parity check matrix of the LDPC codes are interchanged.

59. An apparatus for decoding Low Density Priority Check (LDPC) codes having unequal error probability values in a wireless communication system which channel-codes and transmits information bits, the apparatus comprising:

a variable node decoder for connecting variable nodes to columns of a check matrix of the LDPC codes according to weights of the columns, thereby obtaining probability values;
a first adder for subtracting a signal generated in previous decoding from an output signal of the variable node decoder;
a deinterleaver for deinterlcaving an output signal of the first adder in accordance with the parity check matrix;
a check node decoder for connecting check nodes to the columns of the check matrix of the LDPC codes according to weights of the columns, thereby obtaining probability values of signals output from the deinterleaver;
a second adder for subtracting an output signal of the deinterleaver from an output signal of the check node decoder;
an interleaver for interleaving an output signal of the second adder in accordance with the parity check matrix;
a controller for generating the parity check matrix and controlling deinterleaving and interleaving in accordance with the parity check matrix; and
a memory for storing the parity check matrix of the LDPC codes having unequal error probability values for coding or decoding the information bits according to importance priorities of the information bits,

wherein the deinterleaver is controlled by the

**EP 1 548 948 A1**

controller based on the parity check matrix stored in the memory.

$$H = \begin{bmatrix} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 1 & 0 & 1 & 1 & 0 & 0 & 1 \end{bmatrix}$$

# FIG.1

# FIG.2

EP 1 548 948 A1

301
INFORMATION PART

311
PARITY PART

300
VARIABLE
NODES

| V.N1 deg=6 | V.N2 deg=5 | V.N3 deg=5 | V.N4 deg=4 | V.N5 deg=3 | V.N6 deg=3 | V.N7 deg=2 | V.N8 deg=2 |

○~303 ○~305 ○~307 ○~309 ○~313 ○~315 ○~317 ○~319

INTERLEAVER ~320

330
CHECK
NODES

⊞~331        ⊞~333        ⊞~335        ⊞~337

C.N1          C.N2          C.N3          C.N4

FIG.3

START

ARRANGE IN A SEQUENCE BEGINNING WITH HIGHEST DEGREE BIT TOWARD LOWER DEGREE BIT — 401

i = 0 — 403

FORM SET OF VARIABLE NODES HAVING HIGHEST DEGREE FROM AMONG REMAINING UNASSIGNED VARIABLE NODES — 405

407
NUMBER OF ELEMENTS OF SET > 1 ?
YES

411
j = 0

421
i ← i+NUMBER OF ELEMENTS IN SET

NO

413
ASSIGN INFORMATION BIT TO LARGEST CYCLE ELEMENT IN THE SET

417
j++

415
J < NUMBER OF ELEMENTS IN SET
YES

NO

409
ASSIGN INFORMATION BIT TO THE SINGLE VARIABLE NODE

YES

419
i < K (K = NUMBER OF INPUT BITS)

NO

DETERMINE MAPPING SEQUENCE OF VARIABLE NODES ACCORDING TO BIT ALLOCATION — 423

END

FIG.4

FIG.5

FIG.6

START

INFORMATION
BIT GENERATION — 701

INPUT BIT MAPPING
ACCORDING TO IMPORTANCE
DEGREES BY CODER — 703

CHANNEL CODING — 705

MAPPING — 707

MODULATION — 709

DATA TRANSMISSION — 711

EMD

# FIG.7

START

SIGNAL RECEPTION — 801

DEMODULATION — 803

INVERSE MAPPING — 805

CHANNEL DECODING
ACCORDING TO
IMPORTANCE DEGREES — 807

OUTPUT OF
INFORMATION DATA — 809

END

FIG.8

FIG.9

**European Patent Office**

# EUROPEAN SEARCH REPORT

Application Number

EP 04 03 0172

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | HYEON WOO LEE: "Enabling technologies in HSDPA" PANEL DISCUSSION FOR VTC FALL 2003, [Online] 7 October 2003 (2003-10-07), pages 1-16, XP002320296 Retrieved from the Internet: URL:http://www.eee.strath.ac.uk/vtc2003/vtc2003fall/panelsessions.html> [retrieved on 2005-03-07] * the whole document * * page 7 * ----- | 1-59 | H03M13/11 H04L12/56 |
| Y | P.S. GUINAND, D. BOUDREAU , R. KERR: "Construction of UEP codes suitable for iterative decoding" PROC. OF THE 1999 CANADIAN WORKSHOP ON INFORMATION THEORY, [Online] June 1999 (1999-06), pages 1-4, XP002320297 KINGSTON, ONTARIO, CANADA Retrieved from the Internet: URL:http://www.crc.ca/en/html/fec/home/publications/papers/GUI99a_CWIT_UEP.pdf> [retrieved on 2005-03-07] * the whole document * ----- | 1-59 | |
| | | | TECHNICAL FIELDS SEARCHED (Int.Cl.7) H03M H04L |
| A | LIN-NAN LEE: "LDPC Codes, Application to Next Generation Communication Systems" BEYOND 3G - THE FUTURE OF WIRELESS - FIXED AND MOBILE COMMUNICATIONS, [Online] 8 October 2003 (2003-10-08), pages 1-8, XP002320298 Retrieved from the Internet: URL:http://www.eee.strath.ac.uk/vtc2003/vtc2003fall/2003panelsessions/llee.pdf> [retrieved on 2005-03-07] * the whole document * * page 6 * ----- -/-- | 1-59 | |

The present search report has been drawn up for all claims

| Place of search | Date of completion of the search | Examiner |
|---|---|---|
| The Hague | 7 March 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 04 03 0172

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | ISAKA M ET AL: "ITERATIVE RELIABILITY-BASED DECODING OF TURBO-LIKE CODES" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, vol. VOL. 3 OF 5, 28 April 2002 (2002-04-28), pages 1495-1500, XP001046132 ISBN: 0-7803-7400-2 * page 1497, column 1, line 40 - line 42; figure 3 * ----- | 59 | |
| | | | **TECHNICAL FIELDS SEARCHED (Int.Cl.7)** |

The present search report has been drawn up for all claims

| Place of search | Date of completion of the search | Examiner |
|---|---|---|
| The Hague | 7 March 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)